# EUROPÄISCHE PATENTANMELDUNG

(11) **EP 1 739 447 A1**
(43) Veröffentlichungstag der Anmeldung: **03.01.2007**
(21) Anmeldenummer: 05026538.8
(22) Anmeldetag: 06.12.2005
(51) Int. Cl.: G01R 33/567

(54) **Verfahren zur Erzeugung von Magnetresonanz-Bildern eines sich periodisch bewegenden Objekts unter Verwendung von Navigator-Signalen**

(30) Priorität: 29.06.2005 DE 102005030162
(71) Anmelder: Bruker BioSpin MRI GmbH, 76275 Ettlingen (DE)
(72) Erfinder: Nauerth, Arno, 76872 Erlenbach (bei Kandel) (DE)
(74) Vertreter: Kohler Schmid Möbus

(57) **Zusammenfassung**

Ein Verfahren zur Erzeugung von MR (=Magnetresonanz) Bildern eines sich bewegenden Objekts mit einem sich wiederholenden Bewegungsablauf über untereinander vergleichbare Bewegungszustände, wobei für mindestens einen Bewegungszustand ein für die Erstellung eines MR-Bildes vollständig kodierter Satz von MR-Daten aus einer Vielzahl von aufeinander folgenden MR-Einzelmessungen, deren zeitlicher Abstand kürzer ist als eine Wiederholrate des Bewegungsablaufs, bereit gestellt wird, und wobei als Indikator für die Vergleichbarkeit mehrerer Bewegungszustände jeweils mindestens ein Datenpunkt aus jeder MR-Einzelmessung herangezogen wird, ist dadurch gekennzeichnet, dass als Indikator mindestens ein zusammenhängender Bereich von aufeinander folgenden Datenpunkten innerhalb der MR-Einzelmessung herangezogen wird, wobei sich dieser zusammenhängende Bereich für alle MR-Einzelmessungen innerhalb der jeweiligen MR-Messsequenz identisch bezüglich eingestrahlter HF (=Hochfrequenz) Impulse und geschalteter Gradienten wiederholt. Somit kann eine zuverlässige Zuordnung der aufgenommenen MR-Daten zu den zugehörigen Bewegungszuständen erfolgen, wobei in zeitoptimierter Weise vollständig kodiertere Sätze von MR-Daten ermittelt werden können.

## Beschreibung

Die Erfindung betrifft ein Verfahren zur Erzeugung von MR (=Magnetresonanz) Bildern eines sich bewegenden Objekts mit einem sich wiederholenden Bewegungsablauf über untereinander vergleichbare Bewegungszustände, wobei für mindestens einen Bewegungszustand ein für die Erstellung eines MR-Bildes vollständig kodierter Satz von MR-Daten aus einer Vielzahl von aufeinander folgenden MR-Einzelmessungen, deren zeitlicher Abstand kürzer ist als eine Wiederholrate des Bewegungsablaufs, bereit gestellt wird, und wobei als Indikator für die Vergleichbarkeit mehrerer Bewegungszustände jeweils mindestens ein Datenpunkt aus jeder MR-Einzelmessung herangezogen wird.

Derartige Verfahren zur Abbildung bewegter Objekte sind bereits bekannt aus dem Joumal of Magnetic Resonance in Medicine, MRM 13 (2005).

Insbesondere bei klinischen Anwendungen müssen hochaufgelöste MR-Bilder von bewegten Objekten aufgenommen werden. Dabei handelt es sich meist um Aufnahme des Herzens oder des Abdominalbereichs, wobei es infolge des Herzschlags und der Atembewegung zu einer relativen Bewegung des abzubildenden Objekts gegenüber dem von der MR-Apparatur erzeugten Magnetfeld kommt. Die Erfassung eines 2- oder 3-dimensionalen Bildes erfordert das wiederholte Anlegen von Abbildungsimpulsfolgen mit verschiedenen Phasenkodiergradienten und Rekonstruktion des Bildes. Durch eine kontinuierliche Bewegungsablauf des Objektes, der meist eine Vielzahl, an Bewegungszuständen umfasst, passiert es jedoch, dass die einzelnen MR-Signale in unterschiedlichen Bewegungszuständen aufgenommen werden, was bei der Rekonstruktion des Bildes zu Artefakten, wie Ghostings, Distortions und Verschlechterung der Auflösung führen kann.

Es ist bekannt, dieses Problem zu lösen, indem die Zeitpunkte der Einzelmessungen auf vergleichbare Bewegungszustände des Objekts mittels externer Sensoren getriggert werden. Dies erfordert jedoch, insbesondere bei der Überlagerung mehrerer Einzelbewegungen mit unterschiedlichen Frequenzen, einen erhöhten Zeitaufwand. Da bei dieser Methode stets auf eine bestimmte Flanke des Triggersignals, die einen bestimmten Bewegungszustand des Objekts charakterisiert, gewartet werden muss, kann es darüber hinaus vorkommen, dass sich das Spinsystems in unterschiedlichen Relaxationszuständen befindet, was wiederum zu unterschiedlichen Signalstärken führt.

Einen anderen Ansatz, bei dem auf externe Triggersignale verzichtet werden kann, bietet das Verfahren "Back Projection". Ohne Anwendung eines Phasenkodiergradienten wird dabei ein Indikator bei vollständiger Rephasierung der Spins aufgenommen, so dass eine Aufnahme des Echomaximums als Indikator erfolgt. Da aus dem Bewegungsablauf des Objektes Amplitudenschwankungen des Indikatorsignals resultieren können, kann eine bestimmte Größe der Amplitude einer entsprechenden Schicht des abzubildenden Objekts zugeordnet werden. Diese Methode lässt sich jedoch aufgrund der Dephasierung der Spins bei 2D-FT-Verfahren nicht auf diese anwenden. Nachteilig ist auch, dass als Indikator lediglich ein Punkt, nämlich das Echomaximum, dient, was zu Ungenauigkeiten in der Bestimmung des Bewegungszustandes führen kann.

US 6,552,541 B2 beschreibt ein Verfahren zum Korrigieren von Störeinflüssen auf die MR-Signale einer im Messvolumen einer MR-Apparatur angeordneten Substanz, bei dem ein HF-Anregungsimpuls auf die Substanz eingestrahlt und ein damit erzeugtes zeitabhängiges MR-Signal phasenempfindlich detektiert und digitalisiert wird. Dabei wird aus einem zeitlichen Verlauf des detektierten und digitalisierten MR-Signals ein zeitlicher Verlauf der Phase des MR-Signals bezogen auf eine vorgegebene Referenzphase eines Referenzsignals ermittelt und digitalisiert und daraus eine oder mehrere Korrektur- bzw. Regelgrößen bestimmt. Bei dieser Methode geht nahezu jeder Messpunkt in die Bestimmung der Magnetfetdabweichung und damit in die Regelung ein, wodurch eine erheblich große Regelgenauigkeit gewährleistet ist.

Aufgabe der Erfindung ist es, ein Verfahren zur Erzeugung von MR-Bildern eines sich bewegenden Objekts vorzuschlagen, mit dem eine zuverlässige Zuordnung der aufgenommenen MR-Daten zu den zugehörigen Bewegungszuständen erfolgt und dabei in zeitoptimierter Weise vollständig kodiertere Sätze von MR-Daten ermittelt werden können.

Diese Aufgabe wird erfindungsgemäß dadurch gelöst, dass als Indikator mindestens ein zusammenhängender Bereich von aufeinander folgenden Datenpunkten innerhalb der MR-Einzelmessung herangezogen wird, wobei sich dieser zusammenhängende Bereich für alle MR-Einzelmessungen innerhalb der jeweiligen MR-Messsequenz identisch bezüglich eingestrahlter HF (=Hochfrequenz) Impulse und geschalteter Gradienten wiederholt.

Mit dem erfindungsgemäßen Verfahren können aus einem MR-Experiment Zusatzinformationen zur Bestimmung der Bewegungszustände des Bewegungsablaufs erlangt werden. Somit können die aufgenommenen Einzelmessungen genau einem Bewegungszustand zugeordnet werden. Zur Rekonstruktion eines MR-Bildes werden dann jeweils nur Signale herangezogen, die mit Hilfe des zusammenhängenden Bereichs einzelner Datenpunkte (Indikator) einem bestimmten Bewegungszustand zugeordnet wurden. Die relevanten Bewegungszustände können dabei für unterschiedliche Anwendungen unterschiedlich klassifiziert werden (z.B. Bewegungszustand 1: Atemphase, Bewegungszustand 2:Diastole während Atempause, Bewegungszustand 3: Systole während Atempause usw.). Ein Bewegungszustand muss also nicht zwingend nur eine einzige Momentaufnahme des Bewegungsablaufs enthalten, sondern kann durchaus eine Bewegungsphase umfassen. Der für die Erstellung eines MR-Bildes vollständig kodierter Satz von MR-Daten kann im Rahmen des erfindungsgemäßen Verfahrens aufgenommen werden oder aber bereits von früheren Messungen vorhanden sein.

Die als Indikator verwendeten zusammenhängenden Bereiche von aufeinander folgenden Datenpunkten werden in jeweils gleichem Dephasierungszustand der Kernmagnetisierung aufgenommen. Daher kann bei dem erfindungsgemäßen Verfahren, im Gegensatz zu den aus dem Stand der Technik bekannten Verfahren, durch die Verwendung dieses Indikators die Zuordnung der Einzelmessungen zu den entsprechenden Bewegungszuständen mit hoher Genauigkeit erfolgen.

Das erfindungsgemäße Verfahren erlaubt in kurzer Zeit die Aufnahme einer Vielzahl von MR-Daten verschiedener Bewegungszustände und eine zuverlässige Zuordnung der aufgenommenen Daten zu den entsprechenden Bewegungszuständen. Hierdurch wiederum können Artefakte in den resultierenden MR-Bildern vermieden oder zumindest stark reduziert werden.

Es ist vorteilhaft, wenn der zusammenhängende Bereich einen Teilbereich umfasst, in welchem keine Gradienten anliegen, wobei in diesem Teilbereich das Kernspinsystem rephasiert ist. Auf diese Weise trägt das volle Signal zum Indikator bei.

Eine vorteilhafte Variante des erfindungsgemäßen Verfahrens sieht vor, dass der zusammenhängende Bereich einen Teilbereich umfasst, in welchem ein Rephasierungsgradient, insbesondere ein Scheibenselektionsgradient anliegt, wodurch in diesem Teilbereich das Kernspinsystem rephasiert wird. Hierdurch kann die Messzeit für den Indikator verkürzt werden, wobei durch den Rephasierungsprozess immer noch eine akzeptable Signalstärke erreicht werden kann.

Vorzugsweise umfassen die MR-Einzelmessungen Gradientenecho Messungen. Diese zeichnen sich durch kurze Wiederholzeiten aus, so dass in kurzer Zeit der Bewegungsablauf eindeutig ermittelt werden kann. Prinzipiell ist das erfindungsgemäße Verfahren aber auch mit anderen Pulssequenzen durchführbar.

Um die Messzeit weiter zu verkürzen ist es von Vorteil, wenn die MR-Einzelmessungen Mehrschichtanregungen umfassen. Bei gleicher Wiederholzeit wie bei einer Einzelmessung können auf diese Weise ohne einen Verlust an Signalintensität ein Vielfaches an Messdaten gewonnen werden.

Besonders vorteilhaft ist es, wenn zeitgleich mit den MR-Einzelmessungen einer ersten Kernsorte weitere MR-Einzelmessungen zur Ermittlung des Indikators mit einer zweiten Kernsorte vorgenommen werden. Die Messung des Indikators kann somit mit einer hohen zeitlichen Auflösung erfolgen, ohne die eigentliche Datenaufnahme zu stören. Darüber hinaus kann zur Optimierung der Signalamplitude des Indikators die Schichtdicke, aus der das Indikatorsignal gewonnen wird, nahezu beliebig dick gewählt werden, während die Einzelmessungen zwecks hoher Ortsauflösung an dünnen Schichten durchgeführt werden können. Es ist daher auch kein Problem, wenn die Signalstärke pro Volumeneinheit des zweiten Kernsorte niedriger ist als die Signalintensität der ersten Kernsorte.

Eine Variante des erfindungsgemäßen Verfahrens sieht vor, dass im zusammenhängenden Bereich kein Gradient anliegt, und dass dem zusammenhängenden Bereich ein HF-Anregungsimpuls mit kleinem Flipwinkel vorgeschaltet wird. Auf diese Weise erfolgt eine Breitbandanregung, so dass das gesamte Volumen zum Indikatorsignal beiträgt, ohne die Messsequenz wesentlich zu verlängern, was insbesondere bei Merhschichtaufnahmen interessant ist. Typischerweise werden Pulswinkel von weniger als 10° verwendet.

Bei einer vorteilhaften Weiterbildung dieser Variante werden die Datenpunkte des zusammenhängenden Bereichs durch eine vorgeschaltete scheibenselektive Anregung außerhalb des Messvolumens der MR-Bilder erzeugt. Das Volumen, das zur Messung des Indikatorsignals genutzt wird, kann dann so ausgewählt werden, dass sicher gestellt ist, dass die Aufnahme des Indikatorsignals keinen Störeinfluss auf das Messvolumen der MR-Einzelmessungen hat. Zudem wird damit eine hohe Abtastrate realisiert.

Eine Weiterbildung dieser Variante sieht vor, dass das Messvolumen eine Scheibe ist, deren Ebene gegenüber der Scheibenebene der scheibenselektiven Anregung gekippt ist. Hierdurch wird eine gezielte Triggerung auf einen Bewegungsablauf außerhalb des Messvolumens ermöglicht.

Bei einer weiteren vorteilhaften Weiterbildung wird die scheibenselektiven Anregung zusätzlich für die Sättigung von Kernspins aus in das Messvolumen einfließenden Fluiden, insbesondere von einströmenden Blut, verwendet. Signale der einfließenden Fluide können somit ohne eine separate Sättigungsanregung unterdrückt werden. Die Sättigungsscheibe ist dabei frei wählbar, wird jedoch meist parallel zu der Scheibe des Messvolumens gewählt.

Darüber hinaus kann es vorteilhaft sein, wenn die Anregung und Aufnahme der Datenpunkte des zusammenhängenden Bereichs dem HF-Impuls für die Aufnahme der MR-Daten vorangestellt wird.

Bei dem erfindungsgemäßen Verfahren kann es vorteilhaft sein, wenn für eine Vielzahl von Bewegungszuständen vollständige Datensätze zur Erzeugung von MR-Bildem, die dem jeweiligen Bewegungszustand entsprechen, bereitgestellt werden. Somit ergibt sich die Möglichkeit das Objekt in den verschiedenen Bewegungszuständen abzubilden

Zur Veranschaulichung des Bewegungsablaufs kann aus den MR-Bildern ein periodisch ablaufender Film erstellt werden.

Das erfindungsgemäße Verfahren sieht vor, dass die aufeinander folgenden Datenpunkte im zusammenhängenden Bereich eine MR-Signalamplitude und/oder eine MR-Signalphase aufweisen und zur Gewinnung eines den Bewegungszustand charakterisierenden Parameters mit einem vorgegebenen mathematischen Algorithmus verarbeitet werden.

Vorzugsweise umfasst der Algorithmus einen Polynomial-Fit, insbesondere von 0. und/oder 1. Ordnung.

Darüber hinaus kann es von Vorteil sein, wenn der Algorithmus eine Filterung umfasst. Damit können die für den Betrachter nicht relevanten Bewegungen des Bewegungsablaufs herausgefiltert werden. So kann beispielsweise bei einem Bewegungsablauf, der durch die Atmung und den Herzschlag eines lebenden Objekts hervorgerufen wird, durch eine entsprechende Filterung beispielsweise der alleinige Einfluss des Herzschlags auf den Bewegungsablauf des Objekts beobachtet werden.

Bei einer besonders vorteilhaften Variante des erfindungsgemäßen Verfahrens erfolgt während der MR-Messungen eine online Überprüfung der Vollständigkeit der aufgenommenen Datensätze, wobei bei Erreichen der Vollständigkeit die MR-Messungen beendet werden.

Besonders vorteilhaft ist es, wenn während der MR-Messungen eine online Über prüfung der Vollständigkeit der aufgenommenen Datensätze erfolgt, und die nachfolgenden MR-Einzelmessungen gezielt auf diejenigen beschränkt werden, deren zugehörige Datensätze zum Zeitpunkt der Überprüfung noch nicht vollständig sind. Die Aufnahmedauer wird somit minimiert. Dies kann prinzipiell für einen einzelnen Bewegungszustand oder aber auch für viele Bewegungszustande gleichzeitig erfolgen. Dabei werden die Phasenkodierschritte entsprechend den noch fehlenden Daten angepasst.

Die Aufnahmedauer der Gesamtmessung kann weiter reduziert werden, indem die Anzahl der MR-Einzelmessungen so hoch gewählt wird, dass die statistische Wahrscheinlichkeit für die Vollständigkeit der Datensätze eine vorgegebene Schwelle überschreitet, insbesondere größer als 50% ist.

Eine Weiterbildung dieser Variante sieht vor, dass die MR-Messungen nach einer mehrdimensionalen Fourier-Methode aufgenommen werden, und dass die Schwelle für kleine Werte im K-Raum größer gewählt wird als für große Werte im K-Raum.

Bei einer alternativen Weiterbildung des Verfahrens werden die MR-Messungen nach einer mehrdimensionalen Fourier-Methode aufgenommen, wobei für große Werte im K-Raum eine Unvollständigkeit der Datensätze bewusst in Kauf genommen wird und die fehlenden Werte durch Interpolation zwischen benachbarten vorhandenen Datensätzen ergänzt werden. Dabei kann für einen fehlenden Wert auch der Wert eines Datensatzes, der einem benachbarten Bewegungszustand zugeordnet ist, eingesetzt werden.

Vorzugsweise wird der Indikator aus einer vorgegebenen maximal zulässigen Änderung des Bewegungszustandes bestimmt.

Eine vorteilhafte Ausführungsform des erfindungsgemäßen Verfahrens sieht vor, dass die Gesamtdauer der Aufnahme der Vielzahl von aufeinander folgenden MR-Einzelmessungen gezielt asynchron zum sich wiederholenden Bewegungsablauf gewählt wird, so dass bei wiederholten Aufnahmen der Vielzahl von aufeinander folgenden MR-Einzelmessungen identische Punkte im k-Raum zu unterschiedlichen Phasen des Bewegungszustands aufgenommen werden.

Darüber hinaus ist es vorteilhaft, wenn der Einfluss systematischer Störungen auf den Indikator, insbesondere durch geschaltete Gradienten, erfasst und rechnerisch kompensiert wird. Auf diese Weise wird verhindert, dass fehlerhafte Zuordnungen von MR-Einzelbildern zu den Bewegungsphasen des zu untersuchenden Objekts auftreten. Eine derartige Erfassung des Einflusses systematischer Störungen auf den Indikator kann durch eine Vorabmessung der Störungen, beispielsweise mit Hilfe eines MRI-Phantoms, erfolgen.

Eine Möglichkeit, Störungen durch das Schalten des Phasenkodiergradienten zu verringern, besteht darin, die Phasenkodierung im doppelten Inkrement vom maximal negativen Phasenkodierwert zum maximal positiven Phasenkodierwert, und die fehlenden Zwischenschritte ebenfalls mit doppeltem Dekrement vom maximal positiven zum negativen Phasenkodierwert hin durchzuführen. Somit können Signaländerungen aufgrund von Wirbeistromeffekten, die beim Übergang vom maximal positiven zum maximal negativen Phasenkodierwert auftreten und fälschlicherweise als Atmung oder Herzschlag interpretiert werden können, verringert und somit die Auswertung der Daten erleichtert werden.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1 a,b: MR-Aufnahmen einer Ratte (Transversalschnitt durch das Herz), mit aus der Atmen und Herzschlag-Bewegung resultierenden Artefakten;
- Fig. 2: eine Impuls- und Gradientensequenz nach dem Stand der Technik;
- Fig. 3: eine erfindungsgemäße Impuls- und Gradientensequenz mit Navigatorscan zur Ermittlung eines Indikator gemäß der Erfindung;
- Fig. 4: eine erfindungsgemäße Impuls- und Gradientensequenz mit Navigatorscan während einer Rephasierung;
- Fig. 5: Verlauf der Magnetisierung während eines Navigatorscans und eines Echoscans an verschiedenen Kemsorten;
- Fig. 6: eine erfindungsgemäße Impuls- und Gradientensequenz mit Breitbandanregung zur Ermittlung des Indikators;
- Fig. 7: eine erfindungsgemäße Impuls- und Gradientensequenz zur Ermittlung des Indikators unter Anwesenheit eines zusätzlichen Scheibenselektionsgradienten;
- Fig. 8: eine erfindungsgemäße Impuls- und Gradientensequenz mit vorgeschaltetem Navigatorscan unter Anwesenheit eines Scheibenselektionsgradienten zur Ermittlung des Indikators;
- Fig. 9 a-d: grafische Darstellungen eines unter verschiedenen Algorithmen aus den Amplitudensignalen der Navigatorscans gewonnenen Bewegungs-ablaufs über die Zeit;
- Fig. 10a-d: grafische Darstellungen eines unter verschiedenen Algorithmen aus den Phasensignalen der Navigatorscans gewonnenen Bewegungsablaufs über die Zeit;
- Fig. 11a-d: grafische Darstellung des Bewegungsablaufs aus Fig. 10a mit den daraus separierten Verläufen der Atmung und des Herzschlags;
- Fig. 12a-c: grafische Darstellung des Bewegungsablaufs aus Fig. 10a mit daraus separierten Verläufen der Atmung und des Herzschlags unter gegenüber Fig. 11b,c veränderten Parametern;
- Fig. 13a: aufeinander folgende MR-Bilder eines mit dem erfindungsgemäßen Verfahren aufgenommenen Films der Herzbewegung einer Ratte; und
- Fig. 13b: aufeinander folgende MR-Bilder eines mit dem erfindungsgemäßen Verfahren aufgenommenen Films der Atembewegung einer Ratte.

Bei der Aufnahme von hochaufgelöste MR-Bilder von bewegten Objekten kann es infolge der relativen Bewegung des abzubildenden Objekts gegenüber des Magnetfelds der MR-Apparatur zu Artefakten in den MR-Bildern kommen, da sich die Lage und/oder die Ausdehnung des Objekts aufgrund der Bewegung ständig verändert. Bei der Bewegung kann es sich beispielsweise um Atmung und Herzschlag bei lebenden Objekten handeln. Bewegungsinduzierte Artefakte können jedoch auch bei der Abbildung mittels MR-Verfahren von mechanischen Objekte stattfinden, bei denen beispielsweise Strömungsvorgänge (periodisch schaltende Ventile) auftreten, da auch hier aufeinander folgend Einzelmessungen in verschiedene Bewegungszustände fallen können. Mit Hilfe von Mehrschichtanregungen kann die Zeit zwischen den Anregungen benachbarter Schichten zwar stark verkürzt werden, jedoch können sich schnell bewegende Objekte (z.B. Herzen) auch hiermit nicht artefaktfrei abgebildet werden.

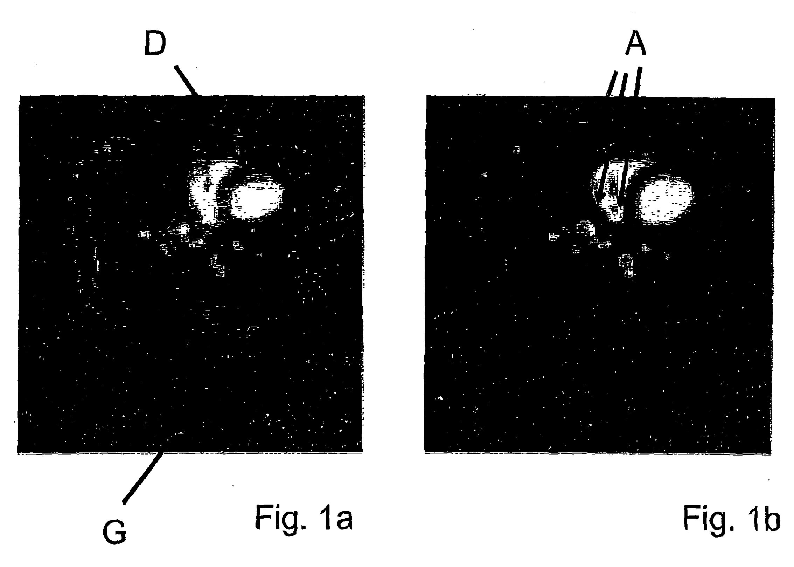

**Fig. 1a** und **1b** zeigen mit einem MR-Verfahren nach dem Stand der Technik aufgenommene Transversalschnitte durch das Herz einer Ratte mit verschiedenen bewegungsinduzierten Artefakten, wie "Ghosting" **G,** "Distortion" **D** (Fig. 1 a) und eine unzureichende Auflösung **A** (Fig. 1b).

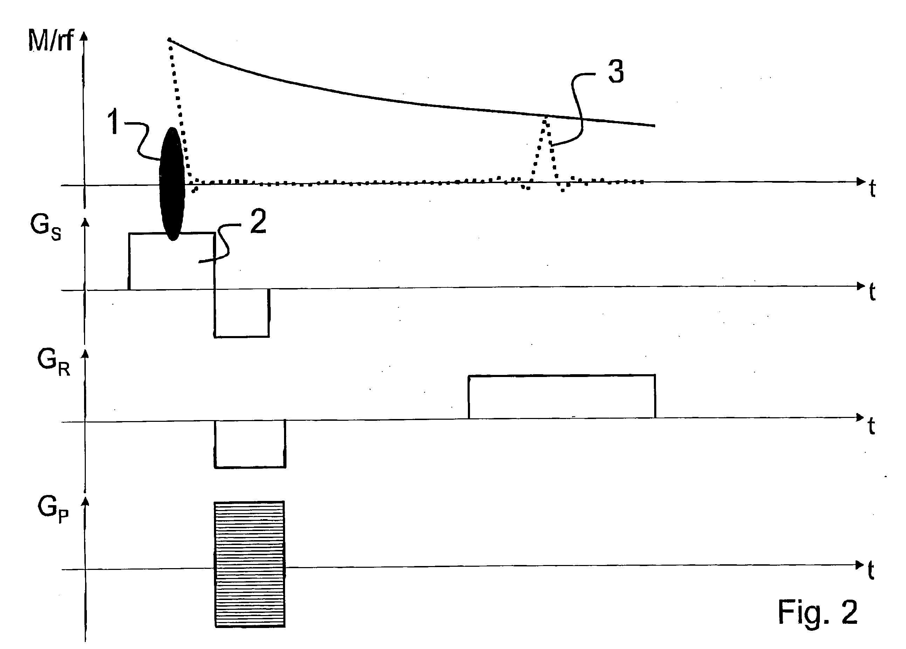

In **Fig. 2** ist eine bekannte Impuls- und Gradientensequenz gezeigt. Ein HF(Hochfrequenz)-Puls **1** wird in Anwesenheit eines Pulses **2** eines Scheibenselektionsgradienteri **G**_{S} auf das Objekt eingestrahlt. Nach einer Phasenkodierung durch einen Phasenkodiergradienten **G**_{P} wird mittels eines Lesegradienten **G**_{R}das Echosignal 3 ausgelesen.

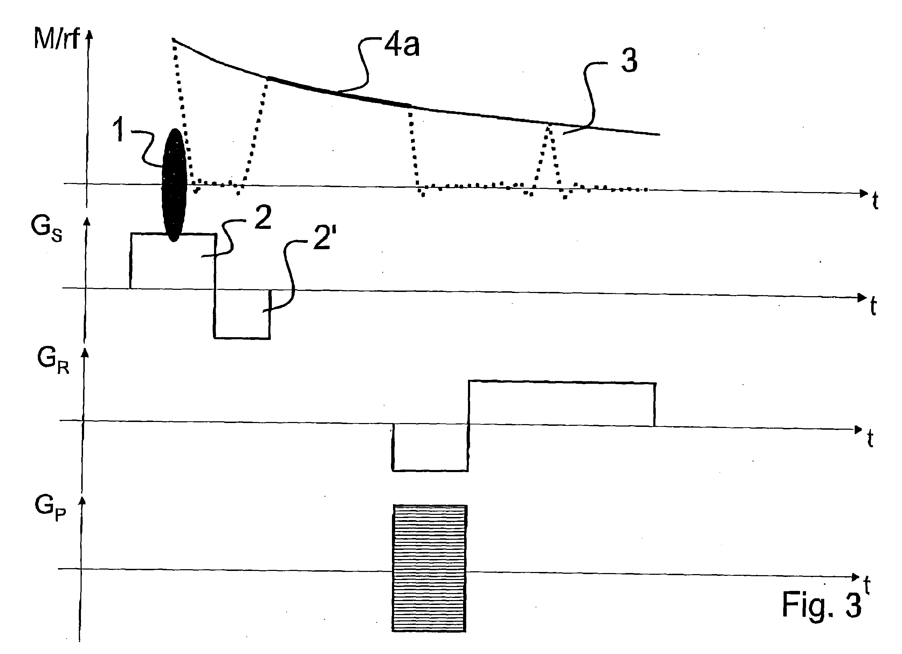

Die vorliegende Erfindung zeigt einen Weg auf, mit dem das Auftreten derartiger Artefakte vermieden oder zumindest stark reduziert werden kann. Dabei werden die Einzelmessung derart gestaltet, dass ein Bereich **4a-f** zusammenhängender Datenpunkte einer jeden Einzelmessung als Indikator zur Identifizierung des Bewegungszustands, in dem die jeweilige Einzelmessung vorgenommen wurde, herangezogen werden kann. Fig. 3 bis 8 zeigen verschiedene Möglichkeiten, auf welche Weise die Einzelmessungen durchgeführt werden können, um die gewünschten Informationen zu bekommen. Durch eine geeignete Auswertung dieser Bereiche 4a-f können die Einzelmessungen bestimmten Bewegungszuständen zugeordnet werden, so dass eine Selektion und/oder Sortierung der vorhandenen MR-Daten vorgenommen werden kann. Somit ist es einerseits möglich, Daten von nicht gewünschten Bewegungszuständen auszusortieren und andererseits MR-Bilder des Objekts in verschiedenen Bewegungszuständen anzufertigen.

Bei dem erfindungsgemäßen Verfahren wird, im Gegensatz zu bekannten Verfahren, bei denen lediglich ein einzelner Punkt, nämlich das Echomaximum als Indikator für den jeweiligen Bewegungszustand dient, ein ganzer Bereich von aufeinander folgenden Datenpunkten herangezogen, die nicht nur durch den Betrag ihrer Amplituden, sondern auch durch ihre relative Lage zueinander den Bewegungszustand des Objekts charakterisieren. Hierdurch ist eine wesentlich genauere Identifizierung des Bewegungszustands, in dem sich das Objekt während der jeweiligen Einzelmessung befindet, möglich.

Eine Impuls- und Gradientensequenz einer Variante des erfindungsgemäßen Verfahrens ist in **Fig. 3** dargestellt. Die Phasenkodierung erfolgt hier zu einem späteren Zeitpunkt als bei der in Fig. 2 dargestellten Gradientensequenz, so dass nach Einstrahlung des HF-Impulses 1 die Spins mittels eines Rephasierungsgradientenpulses **2'** rephasiert werden. Der Verlauf der Magnetisierung des Systems wird im Zeitraum zwischen HF-Anregung und Phasenkodierung beobachtet beziehungsweise aufgezeichnet (Navigatorscan). Der Bereich **4a** von aufeinander folgenden Datenpunkten (Indikatorsignal) dieser Aufzeichnung kann bei dem erfindungsgemäßen Verfahren als Indikator für den jeweiligen Bewegungszustand dienen, in dem sich das Objekt während der entsprechenden Einzelmessung befand. In Fig. 3 ist der Bereich 4a so gewählt, dass die aufeinander folgenden Datenpunkte dieses Bereichs 4a mit einem rephasierten Kernspinsystem aufgenommen wurden. Nach Durchführen des Navigatorscans erfolgen die Phasenkodierung und das Auslesen des Echosignals.

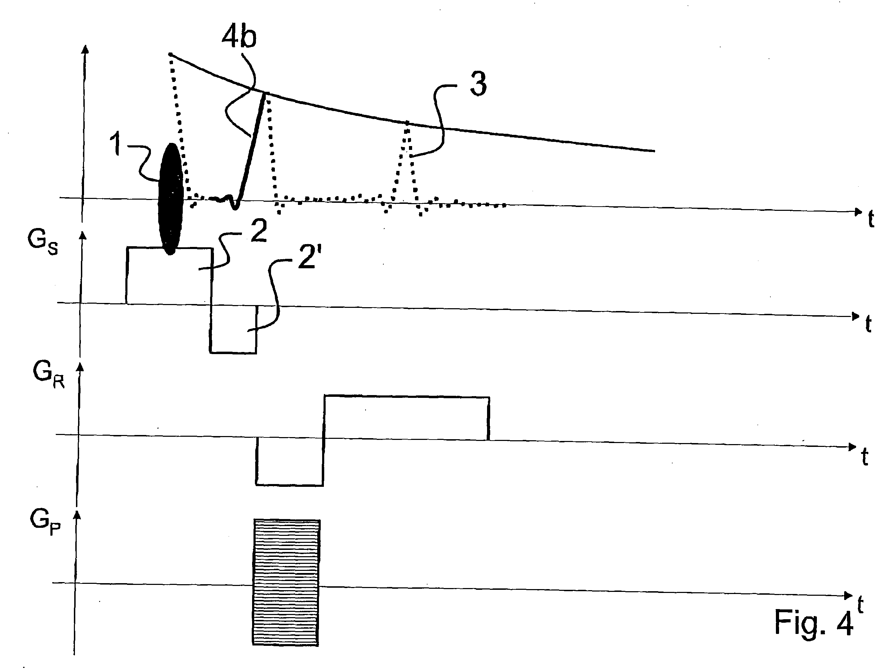

Um die Dauer der Einzelmessung zu reduzieren, kann der Bereich **4b** als Indikator gewählt werden, dessen aufeinander folgende Datenpunkte bereits **w**ährend der Rephasierung der Spins aufgrund des Rephasierungsgradientenpulses 2' aufgenommen werden **(Fig, 4).** Der Navigatorscan ist somit zu einem früheren Zeitpunkt beendet, so dass auch die Phasenkodierung und das Auslesen des Echosignals früher erfolgen können. Die in Fig. 4 gezeigte Gradientensequenz ist so optimiert, dass zu jedem Zeitpunkt ein Gradientenpuls anliegt. Der Bereich 4b umfasst zwar nur einen einzigen Datenpunkt, der unter vollständiger Rephasierung der Spins aufgenommen wurde, jedoch sind auch die während des Rephasierungsprozesses aufgenommenen Datenpunkte des Bereichs **4b** charakteristisch für den Bewegungszustand, indem sich das Objekt während der Aufnahme befindet und tragen somit zur Identifizierung des Bewegungszustands bei.

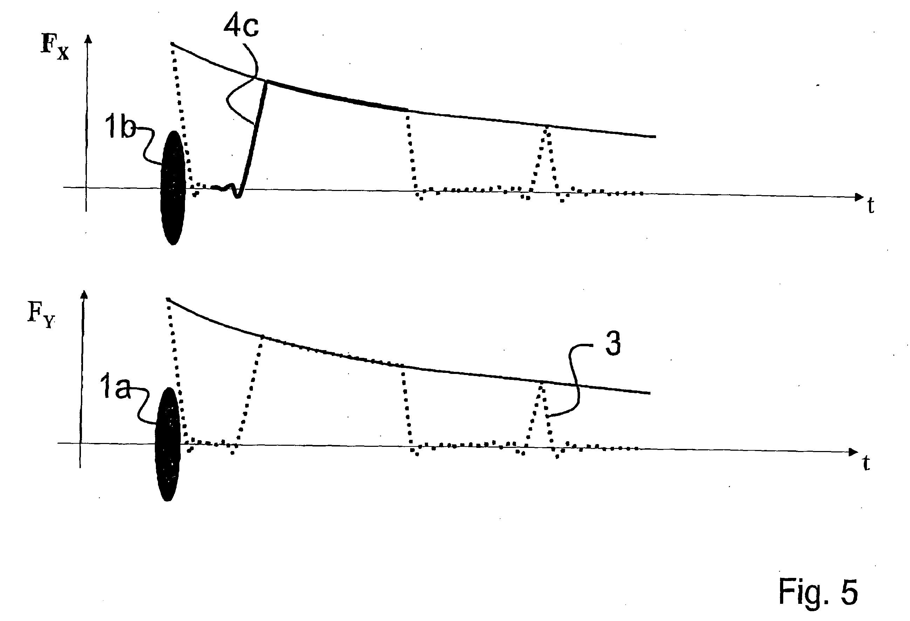

Um die Signalstärke und die zeitliche Auflösung des lndikatersignals zu optimieren können die Aufnahmen des Bereichs **4c** und des Echosignals 3 an unterschiedlichen Kernsorten Fₓ, F_{y} stattfinden. **Fig. 5** zeigt den Verlauf der Magnetisierung während eines Navigatorscans und eines Echoscans an den verschiedenen Kernsorten, deren Spins mittels je eines HF-Pulses **1a, 1b** angeregt werden. Für die Messung des Indikatorsignals eigenen sich beispielsweise ¹¹Na-Kerne. Zwar ist die Signalstärke des MR-Signals pro Volumen dieser Kerne schwächer als die von ¹H-Kernen, aufgrund der Tatsache, dass bei Verwendung von verschiedenen Kernen für die Indikatormessung ein beliebig dickes Volumen verwendet werden kann, können mit dieser Methode trotzdem weit höhere Amplitudenstärken für die Aufnahme des Bereichs 4c realisiert werden.

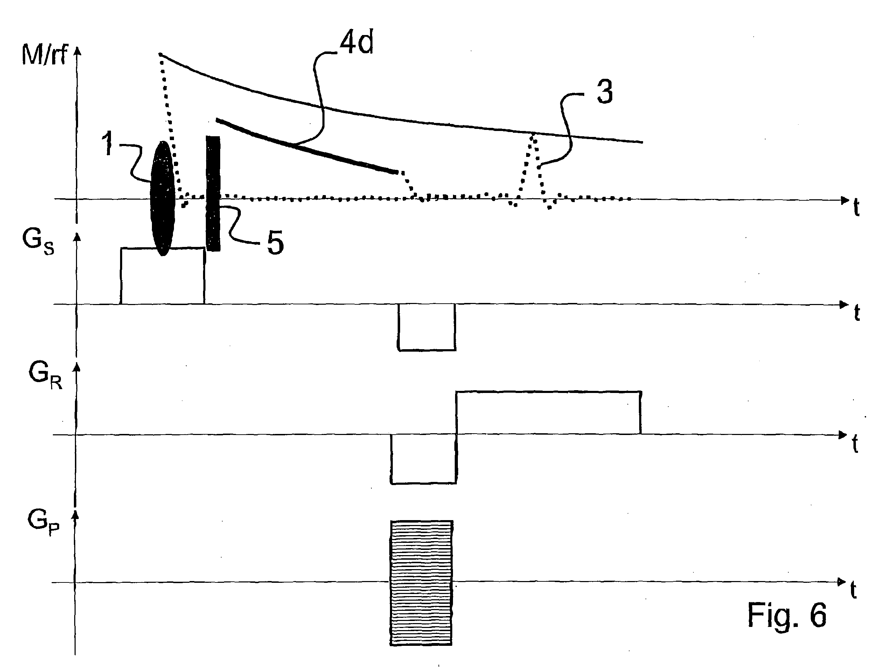

Bei der in **Fig. 6** gezeigten Variante des erfindungsgemäßen Verfahrens wird nach der HF-Anregung durch den HF-Puls 1 zusätzlich ein HF-Anregungsimpuls 5 mit kleinem Flipwinkel eingestrahlt. Während des HF-Anregungsimpulses 5 und der darauf folgenden Aufnahme des zusammenhängenden Bereichs 4d, der als Indikator dient, werden keine Gradienten geschaltet, so dass das gesamte mit dem HF-Anregungsimpuls 5 bestrahlte Volumen des Objekts zur Signalstärke des Bereichs 4d (Indikatorsignal) beiträgt. Dabei muss jedoch beachtet werden, dass in diesem Fall die als Indikatorsignal gemessene Magnetisierung im Echosignal fehlt.

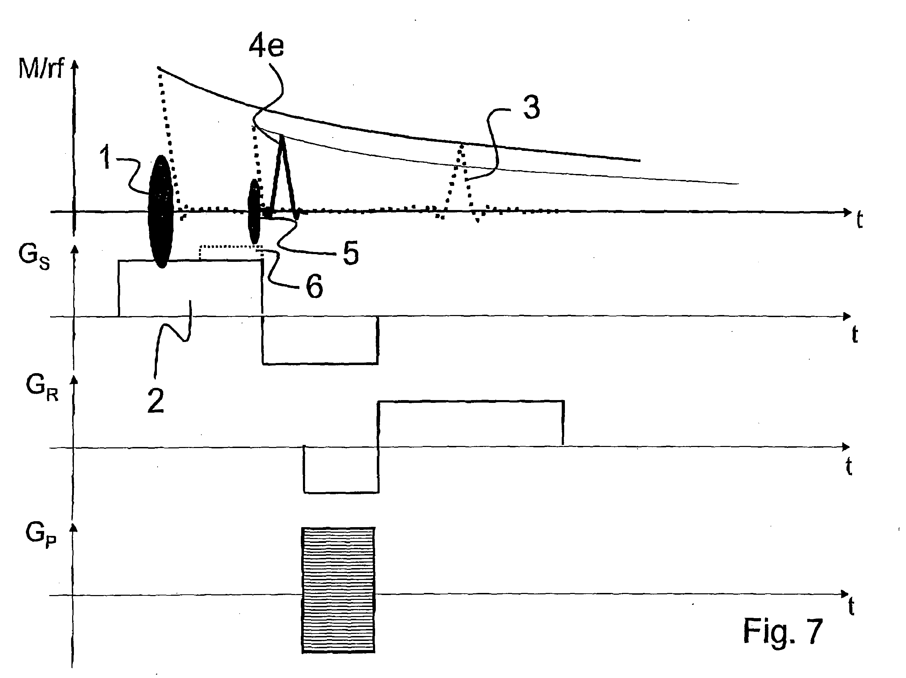

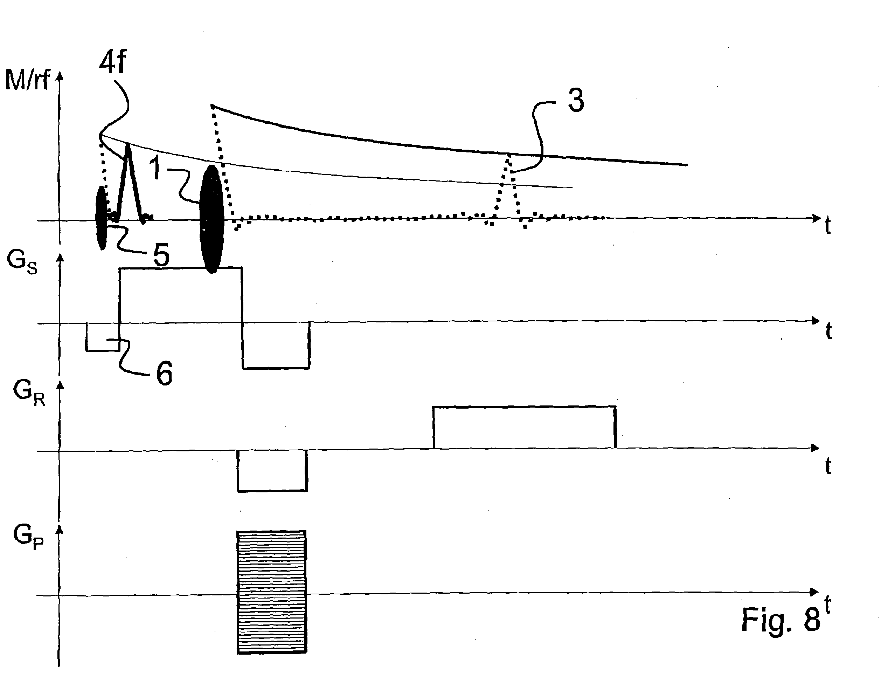

Möchte man daher das Indikatorsignal nicht aus dem gesamten Volumen des Objekts gewinnen, besteht die Möglichkeit, durch Anlegen eines zusätzlichen Pulses 6 des Scheibenselektionsgradienten Gₛ eine beliebig Scheibe des Objektes für die Messung des Bereichs **4e** (Indikatorsignal) auszuwählen. Dabei kann insbesondere berücksichtigt werden, dass die durch den Puls 6 ausgewählte Scheibe nicht im Bereich der durch den Puls 2 des Scheibenselektionsgradienten Gₛ definierten Scheibe, in welcher die Messung des Echosignals 3 erfolgt, liegt. Der HF-Anregungsimpuls 5 mit dem zusätzliche Puls 6 des Scheibenselektionsgradienten G_{S} können dabei dem HF-Puls 1 nachgeschaltet (Fig. 7) oder vorgeschaltet (Fig. 8) sein. Diese Variante kann insbesondere auch bei Mehrschichtaufnahmen angewendet werden. Eine Aufnahme eines Herzens im Mehrschichtverfahren kann demnach beispielsweise so erfolgen, dass zuerst eine Hälfte des Herzens mittels Mehrschicht-MR-Einzelmessungen untersucht wird, während die Indikatorsignale mittels eines geeigneten Scheibenselektionsgradienten aus der anderen Hälfte des Herzens gewonnen werden und danach mittels eines anderen Scheibenselektionsgradienten die Indikatormessungen an der bereits durch MR-Einzelmessungen untersuchten Hälfte des Herzens durchgeführt werden, so dass auch die zweite Hälfte des Herzens ungestört mittels Messungen der Echosignale 3 aufgenommen werden kann.

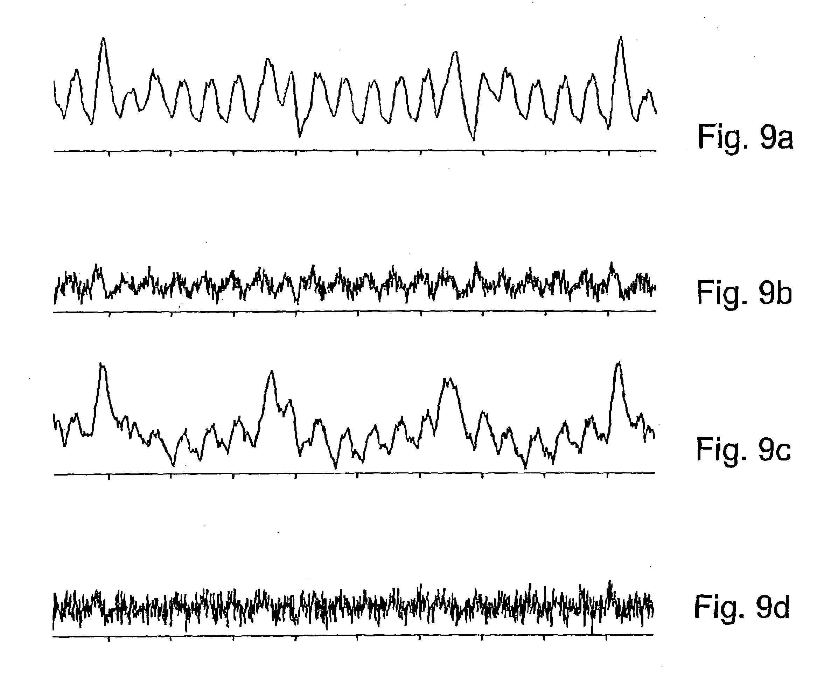

Die während der Einzelmessungen aufgenommenen Bereiche 4a-f werden mittels eines mathematischen Algorithmus verarbeitet. **Fig. 9a-d** zeigen Bewegungsabläufe die aus den Amplitudensignalen einer Vielzahl an aufgenommenen Bereichen 4 mittels verschiedener Algorithmen ermittelt wurden. Als Objekt diente eine lebende Ratte. Fig. 9a zeigt den zeitlichen Verlauf der Mittelwerte (Polynomfit 0. Ordnung) der Amplitudensignale der einzelnen Bereiche. Die Ableitung der Kurve aus Fig. 9a ist in Fig. 9b gezeigt. Alternativ oder ergänzend dazu kann der Bewegungsablauf auch mittels einer lineare Regression (Polynomfit 1. Ordnung) ermittelt werden (Fig. 9c). Insbesondere aus den Fig. 9a und 9c kann man erkennen, dass die Form der Kurven aus einer Überlagerung zweier Frequenzen resultiert, die der Atem- und der Herzfrequenz der Ratte zugeordnet werden können. Fig. 9d zeigt wiederum die Ableitung der Kurve aus Fig. 9c. Die unterschiedlichen Darstellungen aus Fig. 9a-d sind hilfreich, da jeweils unterschiedliche Aspekte des Bewegungsablaufs besser dargestellt sind. So ist bei dem in Fig. 9a-d dargestellten Beispiel in der Auftragung von Fig. 9c die Atmung der Ratte wesentlich deutlicher zu erkennen als bei der aus den Polynomial-Fits 0. Ordnung ermittelten Kurve aus Fig. 9a. Dies stellt eine wesentliche Verbesserung gegenüber dem Stand der Technik dar. Eine Darstellung des Bewegungsablaufs mittels Polynomial-Fits 1. Ordnung der Indikatorsignale ist bei bekannten Verfahren nämlich gar nicht möglich, da ein einziger Datenpunkt nicht in Form eines Polynoms 1. Ordnung angefittet werden kann.

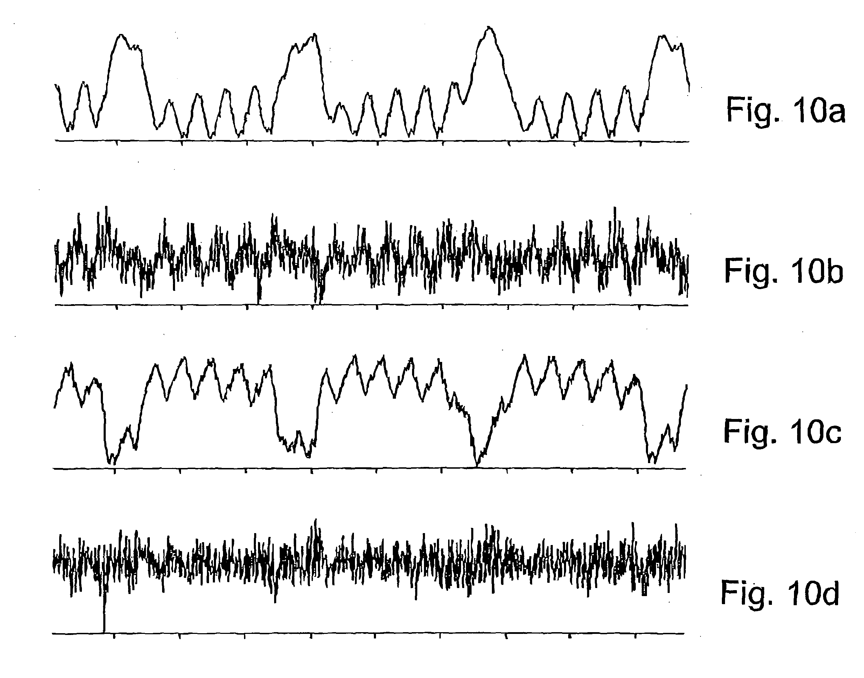

**Fig. 10a bis d** zeigen die aus den Phasensignalen benachbarter Bereiche 4 ermittelten Bewegungsabläufe, welche mittels eines Polynomial-Fits 0. Ordnung (Fig. 10a), Ableitung desselben (Fig. 10b), Polynomial-Fits 1. Ordnung (Fig. 10c) und dessen Ableitung (Fig. 10d) ermittelt wurden.

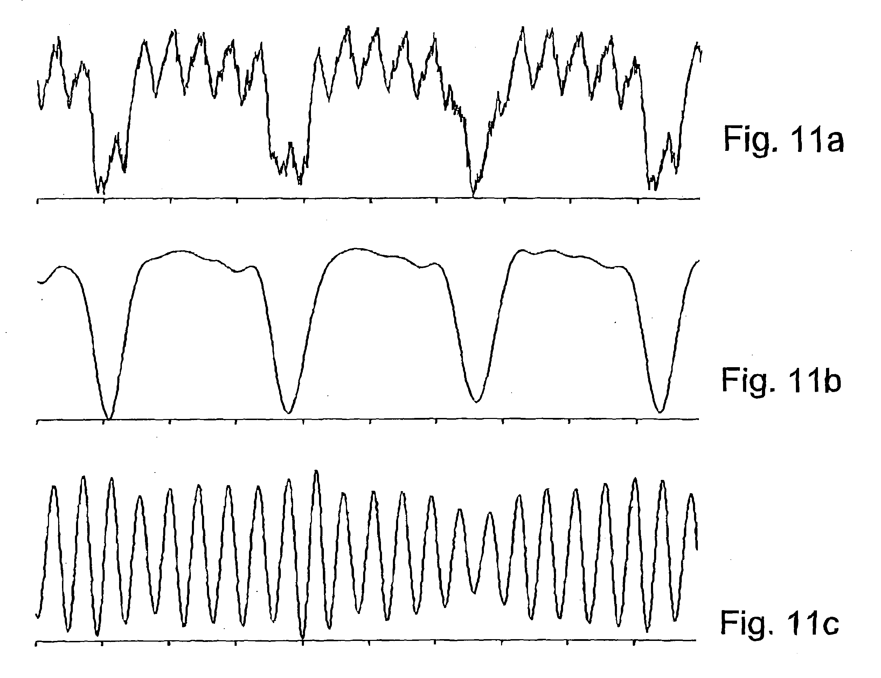

Mit Hilfe eines Datenverarbeitungsprogramms können unter einer gewissen Vorgabe an Parametern die Bewegungen aufgrund des Herzschlages und der Atmung der untersuchten Ratte, die in **Fig. 11a** (entspricht Fig. 10c) zu einem Bewegungsablauf überlagert sind **(Fig. 11b,c),** separiert werden.

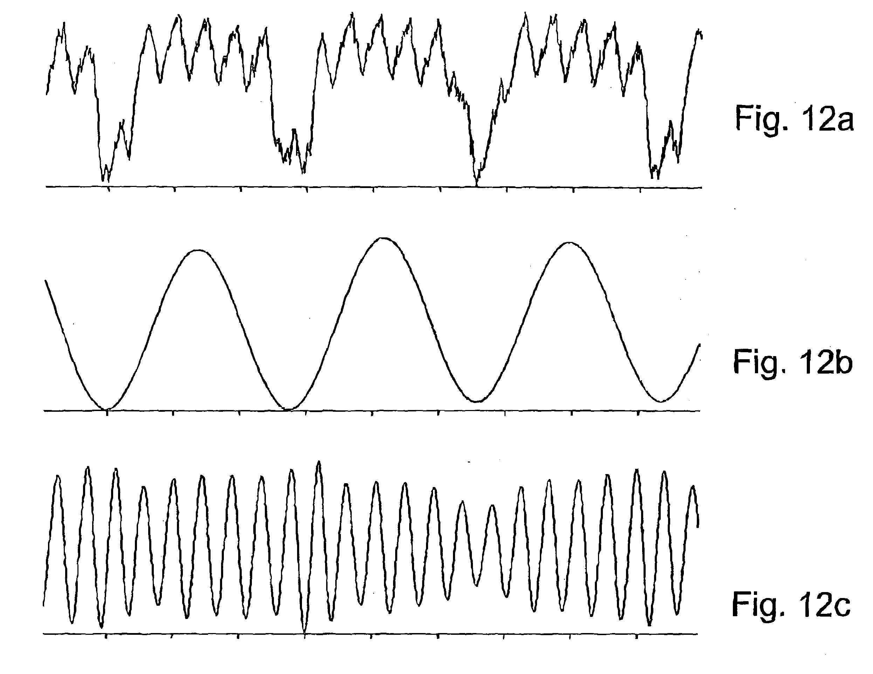

**Fig. 12a-c** zeigen eine Separation der Bewegungen aufgrund des Herzschlags und der Atmung unter veränderten Parametern.

Die separierten Bewegungen können dann jeweils in Teilbewegungszustände eingeteilt werden, welche dann in einer 2D-Matrix dargestellt werden können. Jeder Eintrag der 2D-Matrix stellt dann einen Bewegungszustand des Objektes dar, denen die Einzelmessungen zugeordnet werden können.

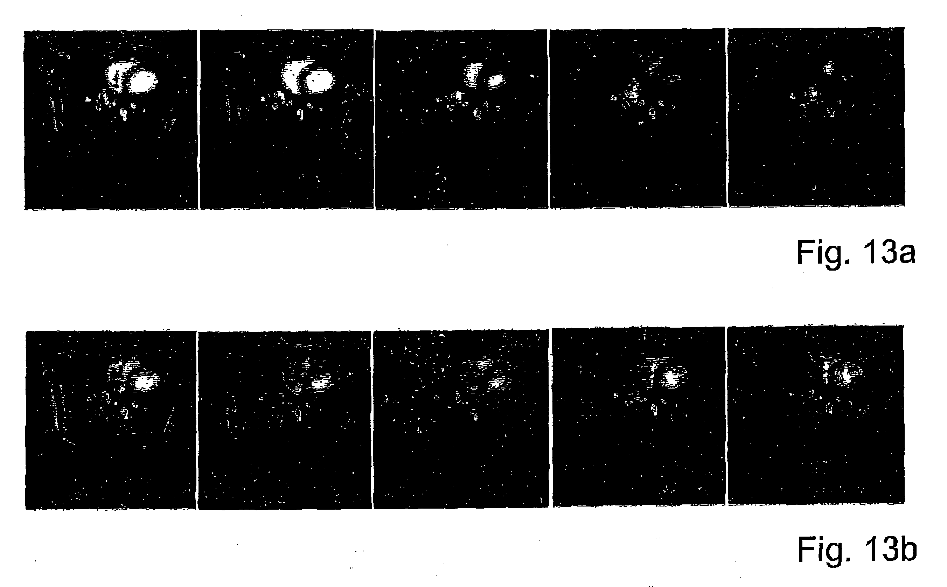

Durch die Separation der einzelnen Bewegungen ist es auch möglich, Filme des aufgenommenen Objekts zu erzeugen, die lediglich eine Bewegung des Bewegungsablaufs (z.B. nur die Atmung des untersuchten Tieres) zeigen, so dass ausschließlich der Einfluss dieser Bewegung auf das Objekt studieren kann. Fig. **13a** zeigt beispielsweise Bilder eines Films des schlagenden Herzens einer Ratte mit "angehaltenem Atem", während in **Fig. 13b** der Einfluss der Atmung derselben Ratte bei einem "scheinbaren Herzstillstand" beobachtet werden kann.

### Bezugszeichenliste

- 1: HF-Puls
- 2: Puls eines Scheibenselektionsgradienten
- 2': Rephasierungsgradientenpuls
- 3: Echosignal
- 4: Bereich
- 5: HF-Anregungsimpuls mit kleinem Flipwinkel
- 6: zusätzlicher Pulses des Scheibenselektionsgradienten G_{S}
- A: unzureichende Auflösung
- D: D istortion
- G: Ghosting
- G_{R}: Lesegradient
- G_{P}: Phasenkodiergradient
- Gs: Scheibenselektionsgradient

## Patentansprüche

1. Verfahren zur Erzeugung von MR (=Magnetresonanz) Bildem eines sich bewegenden Objekts mit einem sich wiederholenden Bewegungsablauf über untereinander vergleichbare Bewegungszustände, wobei für mindestens einen Bewegungszustand ein für die Erstellung eines MR-Bildes vollständig kodierter Satz von MR-Daten aus einer Vielzahl von aufeinander folgenden MR-Einzelmessungen, deren zeitlicher Abstand kürzer ist als eine Wiederholrate des Bewegungsablaufs, bereit gestellt wird, und wobei als Indikator für die Vergleichbarkeit mehrerer Bewegungszustände jeweils mindestens ein Datenpunkt aus jeder MR-Einzelmessung herangezogen wird,
**dadurch gekennzeichnet,**
**dass** als Indikator mindestens ein zusammenhängender Bereich von aufeinander folgenden Datenpunkten innerhalb der MR-Einzelmessung herangezogen wird, wobei sich dieser zusammenhängende Bereich für alle MR-Einzelmessungen innerhalb der jeweiligen MR-Messsequenz identisch bezüglich eingestrahlter HF (=Hochfrequenz) Impulse und geschalteter Gradienten wiederholt.

2. Verfahren nach Anspruch 1, **dadurch gekennzeichnet, dass** der zusammenhängende Bereich einen Teilbereich umfasst, in welchem keine Gradienten anliegen, und dass in diesem Teilbereich das Kernspinsystem rephasiert ist.

3. Verfahren nach einem der vorhergehenden Ansprüche, **dadurch gekennzeichnet, dass** der zusammenhängende Bereich einen Teilbereich umfasst, in welchem ein Rephasierungsgradient, insbesondere ein Scheibenselektionsgradient anliegt, wodurch in diesem Teilbereich das Kernspinsystem rephasiert wird.

4. Verfahren nach einem der vorhergehenden Ansprüche, **dadurch gekennzeichnet, dass** die MR-Einzelmessungen Gradientenecho Messungen umfassen.

5. Verfahren nach einem der vorhergehenden Ansprüche, **dadurch gekennzeichnet, dass** die MR-Einzelmessungen Mehrschichtanregungen umfassen.

6. Verfahren nach einem der vorhergehenden Ansprüche, **dadurch gekennzeichnet, dass** zeitgleich mit den MR-Einzelmessungen einer ersten Kernsorte weitere MR-Einzelmessungen zur Ermittlung des Indikators mit einer zweiten Kernsorte vorgenommen werden.

7. Verfahren nach einem der Ansprüche 1, 2 oder 4 bis 6, **dadurch gekennzeichnet, dass** im zusammenhängenden Bereich kein Gradient anliegt, und dass die Datenpunkte des zusammenhängenden Bereichs durch einen vorgeschalteten HF-Anregungsimpuls mit kleinem Flipwinkel erzeugt werden.

8. Verfahren nach einem der Ansprüche 1 bis 6, **dadurch gekennzeichnet, dass** die Datenpunkte des zusammenhängenden Bereichs durch eine vorgeschaltete scheibenseiaktive Anregung außerhalb des Messvolumens der MR-Bilder erzeugt werden.

9. Verfahren nach Anspruch 8, **dadurch gekennzeichnet, dass** das Messvolumen eine Scheibe ist, deren Ebene gegenüber der Scheibenebene der scheibenselektiven Anregung gekippt ist.

10. Verfahren nach einem der Ansprüche 8 oder 9, **dadurch gekennzeichnet, dass** die scheibenselektiven Anregung zusätzlich für die Sättigung von Kernspins aus in das Messvolumen einfließenden Fluiden, insbesondere von einströmenden Blut, verwendet wird.

11. Verfahren nach einem der vorhergehenden Ansprüche, **dadurch gekennzeichnet, dass** Anregung und Aufnahme der Datenpunkte des zusammenhängenden Bereichs dem HF-Impuls für die Aufnahme der MR-Daten vorangestellt wird.

12. Verfahren nach einem der vorhergehenden Ansprüche, **dadurch gekennzeichnet, dass** für eine Vielzahl von Bewegungszuständen vollständige Datensätze zur Erzeugung von MR-Bildern, die dem jeweiligen Bewegungszustand entsprechen, bereitgestellt werden.

13. Verfahren nach Anspruch 12, **dadurch gekennzeichnet, dass** aus den MR-Bildern ein periodisch ablaufender Film erstellt wird.

14. Verfahren nach einem der vorhergehenden Ansprüche, **dadurch gekennzeichnet, dass** die aufeinander folgenden Datenpunkte im zusammenhängenden Bereich eine MR-Signalamplitude und/oder eine MR-Signalphase aufweisen und zur Gewinnung eines den Bewegungszustand charakterisierenden Parameters mit einem vorgegebenen mathematischen Algorithmus verarbeitet werden.

15. Verfahren nach Anspruch 14 **dadurch gekennzeichnet, dass** der Algorithmus einen Polynomial-Fit, insbesondere von 0, und/oder 1. Ordnung, umfasst.

16. Verfahren nach einem der Ansprüche 14 oder 15, **dadurch gekennzeichnet, dass** der Algorithmus eine Filterung umfasst.

17. Verfahren nach einem der vorhergehenden Ansprüche, **dadurch gekennzeichnet, dass** während der MR-Messungen eine online Überprüfung der Vollständigkeit der aufgenommenen Datensätze erfolgt, und dass bei Erreichen der Vollständigkeit die MR-Messungen beendet werden.

18. Verfahren nach einem der vorhergehenden Ansprüche, **dadurch gekennzeichnet, dass** während der MR-Messungen eine online Überprüfung der Vollständigkeit der aufgenommenen Datensätze erfolgt, und dass die nachfolgenden MR-Einzelmessungen gezielt auf diejenigen beschränkt werden, deren zugehörige Datensätze zum Zeitpunkt der Überprüfung noch nicht vollständig sind.

19. Verfahren nach einem der vorhergehenden Ansprüche, **dadurch gekennzeichnet, dass** die Anzahl der MR-Einzelmessungen so hoch gewählt wird, dass die statistische Wahrscheinlichkeit für die Vollständigkeit der Datensätze eine vorgegebene Schwelle überschreitet, insbesondere größer als 50% ist.

20. Verfahren nach Anspruch 19, **dadurch gekennzeichnet, dass** die MR-Messungen nach einer mehrdimensionalen Fourier-Methode aufgenommen werden, und dass die Schwelle für kleine Werte im K-Raum größer gewählt wird als für große Werte im K-Raum.

21. Verfahren nach Anspruch 17 oder 18, **dadurch gekennzeichnet, dass** die MR-Messungen nach einer mehrdimensionalen Fourier-Methode aufgenommen werden, und dass für große Werte im K-Raum eine Unvollständigkeit der Datensätze bewusst in Kauf genommen wird und die fehlenden Werte durch Interpolation zwischen benachbarten vorhandenen Datensätzen ergänzt werden.

22. Verfahren nach einem der vorhergehenden Ansprüche, **dadurch gekennzeichnet, dass** der Indikator aus einer vorgegebenen maximal zulässigen Änderung des Bewegungszustandes bestimmt wird.

23. Verfahren nach einem der vorhergehenden Ansprüche, **dadurch gekennzeichnet, dass** die Gesamtdauer der Aufnahme der Vielzahl von aufeinander folgenden MR-Einzelmessungen gezielt asynchron zum sich wiederholenden Bewegungsablauf gewählt wird.

24. Verfahren nach einem der vorhergehenden Ansprüche, **dadurch gekennzeichnet, dass** der Einfluss systematischer Störungen auf den Indikator, insbesondere durch geschaltete Gradienten, erfasst und rechnerisch kompensiert wird.
